Europäisches Patentamt

(19) European Patent Office

Office européen des brevets

(11) Publication number : **0 554 265 B1**

(12) **EUROPEAN PATENT SPECIFICATION**

(45) Date of publication of patent specification :
25.05.94 Bulletin 94/21

(51) Int. Cl.⁵ : **H03M 1/14**

(21) Application number : **91916191.9**

(22) Date of filing : **20.09.91**

(86) International application number :
**PCT/EP91/01809**

(87) International publication number :
**WO 92/08287 14.05.92 Gazette 92/11**

(54) **TWO-STEP ANALOG-TO-DIGITAL CONVERTER.**

(30) Priority : **24.10.90 IT 2186390**

(43) Date of publication of application :
**11.08.93 Bulletin 93/32**

(45) Publication of the grant of the patent :
**25.05.94 Bulletin 94/21**

(84) Designated Contracting States :
**DE DK ES FR GB GR NL SE**

(56) References cited :
PATENT ABSTRACTS OF JAPAN, Vol. 10, No.
61 (E-387)(2118) 11 March 1986 & JP-A-60 214
120
PATENT ABSTRACTS OF JAPAN, Vol. 8, No.
107 (E-245)(1544) 19 May 1984 & JP-A-59 022
440
IEEE JOURNAL OF SOLID-STATE CIRCUITS,
Vol. 24, No. 2, April 1989, New York US, pages
241-249, J. Doernberg et Al. : "A 10-Bit 5-
Msample/s CMOS Two-Step Flash ADC"
IBM TECHNICAL DISCLOSURE BULLETIN,
Vol. 32, No. 3B, August 1989, New York US,
pages 348-349; "N Bit Sampling Half Flash
Analog-to-Digital Converter using only 2**N/2
Comparators"

(56) References cited :
PATENT ABSTRACTS OF JAPAN; Vol. 14, No.
518 (E-100), 14 November 1990 & JP-A-2 215
229
IEEE JOURNAL OF SOLID-STATE CIRCUITS,
Vol. 24, No. 6, 6 December 1989, New York US,
pages 1492-1497, N.K. MAYES et Al.: "A Mul-
tistep A/D Converter Family with Efficient
Architecture"

(73) Proprietor : **ITALTEL SOCIETA ITALIANA
TELECOMUNICAZIONI s.p.a.**
P.le Zavattari, 12
I-20149 Milano (IT)

(72) Inventor : BAGGINI, Barbara
Via Achille Grandi, 11
I-27100 Pavia (IT)
Inventor : COPPERO, Luciana
Via Bona di Savoia, 10
I-27100 Pavia (IT)
Inventor : MALOBERTI, Franco
Villaggio dei Pioppi
I-27020 Torre d'Isola (IT)
Inventor : PALMISANO, Giuseppe
Via Robecchi Bricchetti, 46
I-27100 Pavia (IT)

(74) Representative : Giustini, Delio et al
c/o Italtel Società Italiana
Telecomunicazioni s.p.a.
P.O. Box 10
I-20019 Settimo Milanese (MI) (IT)

# Description

The present invention refers to a two-step analog-to-digital converter for the conversion of an analog electric signal into a digital electric signal. In the first step the most significant bits (MSBs) are coded and in the second step the last significant bits (LSBs) of the digital code are determined.

This converter relies on flash technique, where the input to be coded is simultaneously compared to a plurality of reference voltages.

Some known implementations of the two-step flash conversion, require two resistive ladders, one for the MSBs and the other one for the LSBs. The comparators employed in the two subsequent conversion steps are the same.

This implementation is disadvantageous as regards silicon die size, considering also that the resistive ladder value derives its lower limit from power dissipation specification.

It is also necessary to generate two extra reference voltages, scaled down by 2 N/2 with respect to full scale values, where N is the conversion bit number. These voltages bias the additional ladder and have to determine the reference levels for the LSBs with the same accuracy as the levels for the MSBs on main resistance. Possible inaccuracies in this operation can originate the loss of intrinsic monotonic nature of potentiometric converters, as well as a downturn of the converter absolute linearity tied to the accuracy of the division of the full scale voltage by the resistive ladder.

To avoid these drawbacks, some known solutions propose a conversion scheme where the LSBs are determined by using the same resistive ladder of the MSBs coarse conversion, introducing an amplifier circuit with gain equal to $2^{N/2}$. This amplifier has a loop gain-bandwidth product equal to the product between the open loop cut off frequency and the feedback factor, which is close to $1/2^{N/2}$. This involves the design of an operational amplifier having a potential operation speed $2^{N/2}$ times higher than the one actually employed, with the simultaneous charge of a high slew rate specification due to the high input capacitive load, equal to $2^{N/2}.Cin$, where Cin is the input capacitance.

IEEE Journal of Solid-State Circuits, 24(1989)(ii) No. 6, New York, pages 241 to 249 discloses a multistep converter comprising $2^N$ resistors and $2^{N/2}-1$ comparators upon which the preamble of present claim 1 is based.

This prior art converter requires a subtractor to carry out the difference between the analog input value to be converted and its coarse approximation, and an additional shortcoming resides in the large number of switches on the resistive ladder.

The object of the present invention is to realize the analog-to-digital converter of the above type using a single resistive ladder, which overcomes such drawbacks. The converter forming the object of the present invention gets to obtain good operation speed, low power dissipation and limited silicon die size while preserving the monotonic nature of potentiometric converters.

These targets are reached through the invention consisting of an analog-to-digital converter for the conversion of an analog input signal to a N bit digital code, including:

a sample and hold circuit receiving at its input terminal the analog signal to be converted, the sample and hold circuit comprising a capacitor, the upper plate of which is connected to the input terminal;

a ladder of resistances connected in series between two reference voltage sources for the generation of intermediate comparison voltages, said ladder consisting of $2^N$ elementary resistances clustered in $2^{N/2}$ segments, each one comprising $2^{N/2}$ elementary resistances;

a set of $2^{N/2}$ -1 comparators connectable for the comparison between the input signal and said intermediate reference thresholds;

a plurality of latches connected to the outputs of said comparators;

a coder to associate a digital code to the output configuration of said comparators, according to preset rules;

a storage buffer to store the digital code produced;

characterized by the inclusion of a switch block able to connect the reference inputs of said comparators to the elementary resistances of a predetermined segment, and whereby the sample and hold circuit receives as reference a pedestal voltage and the analog ground voltage corresponding to the voltage of the middle point of said ladder of resistances, said pedestal voltage being selected by a combinatorial logic circuit, connected to the outputs of said latches, by means of one of the switches of another switch block, said switches being provided to connect the taps between said segments or one of the reference voltage sources to the lower plate of the capacitor of the sample and hold circuit.

According to the invention, it is supposed the reuse of the same resistive ladder for the conversion both of the MSBs and of the (LSBs) without adding further analog circuitry, switching subsequently the same set of comparators from the main resistive ladder to one of its segments. It is thus obtained a considerable save in the silicon die size and a limited power dissipation.

The invention shall be now described making reference to a preferred realization form, shown in the figures enclosed, where:

Fig. 1 shows a general block diagram of a converter according to the prior art;

Fig. 2 shows in detail the architecture of the resistive ladder of fig. 1;

Fig. 3 shows a block diagram of the preferred embodiment of the converter according to the invention; and

Fig. 4 shows the time trend of the control phases $\Phi1$-$\Phi4$ and of the S/H control phase.

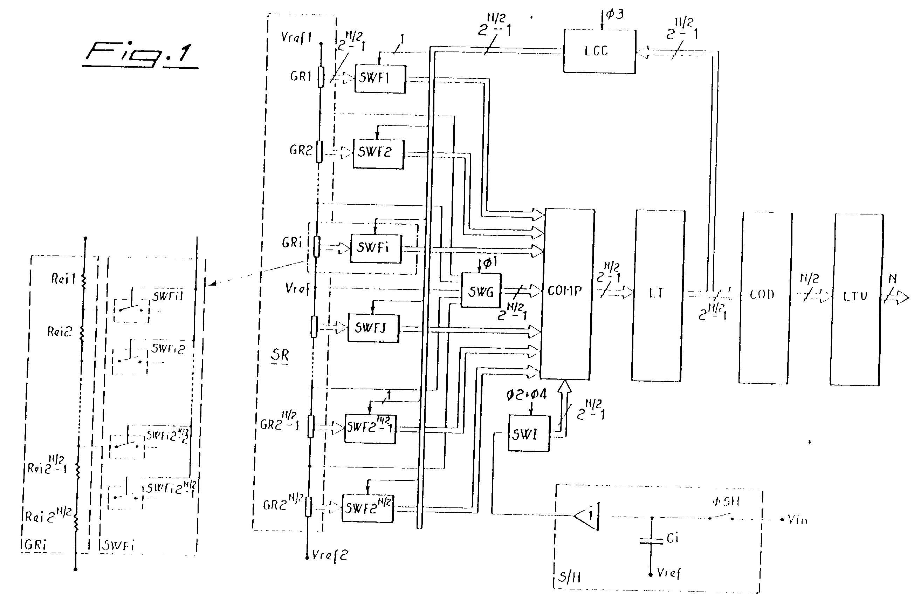

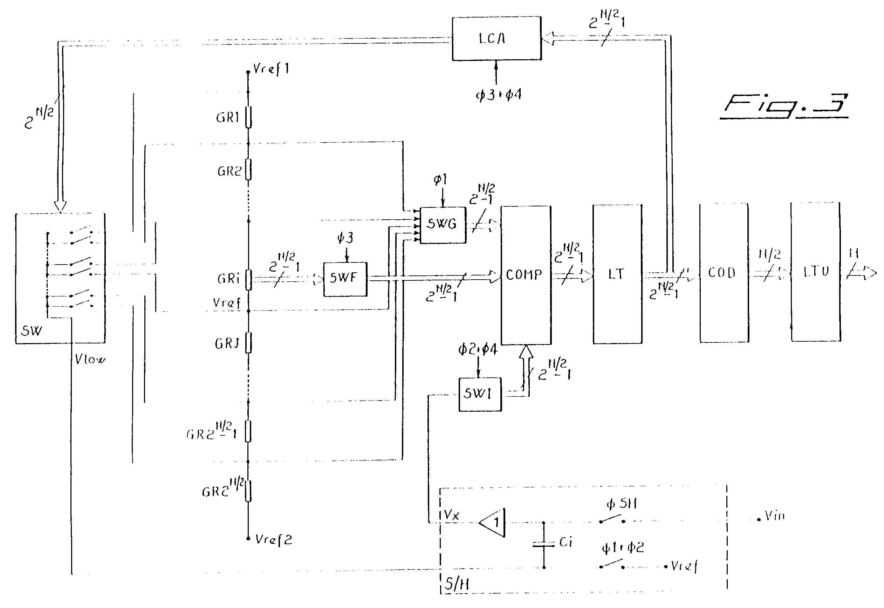

Referring to Fig. 1, the converter in accordance with the prior art teaching includes a resistive ladder labelled SR, a set of comparators or comparing elements ($2^{N/2} - 1$ in number), clustered in the COMP block.

More in detail, each comparator can selectively be connected to the taps of segments GR (case A), to the taps of the single elementary resistances Rei of a chosen segment GR (case B) and to the output of the sample and hold circuit S/H (case C). In case A the connection is made through a plurality of switches SWG; in case B it is made by a controlled switch block (SWF) selected by a combinatorial circuit (LCC) whose inputs matches the outputs of said latches LT; finally in case C, through a plurality of switches SWI. The connection to the reference voltages and to the input voltage takes place on different times.

The $2^{N/2}-1$ outputs of comparators are connected to the same number of latches or hold circuits forming the LT block, and from these ones to the encoder COD whose generated code is stored in the output latches LTU. It is also provided a combinatorial logic circuitry LCC between the block LT and switch blocks SWF.

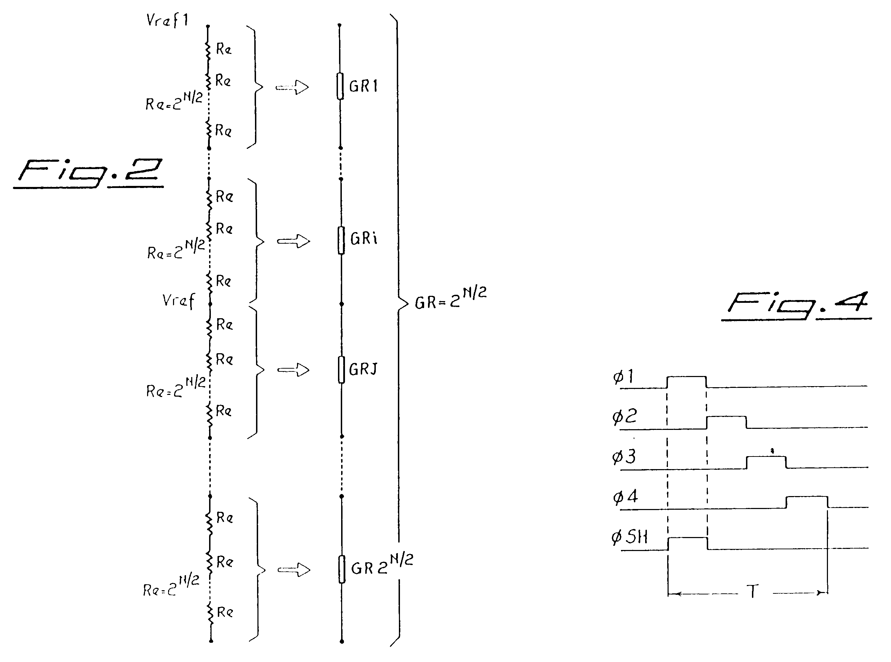

The resistive ladder SR is made of 2N elementary resistances Re of equal value, where N is the number of bits by which the analog signal shall be coded, clustered in $2^{N/2}$ segments, each one consisting of $2^{N/2}$ elementary resistances (see Fig. 2).

The terminals of the ladder SR are connected to two reference voltages Vref1 and Vref2 defining the dynamic range of the input signal. Voltage values available at the taps of the main segments GR represent the decisional thresholds for the conversion of the MSBs and are forced at the comparators COMP through the closing of the $2^{N/2}-1$ switches forming SWG. Voltages available at the taps of the elementary resistances Re inside each segment GR represent the reference levels for the determination of the LSBs. In this case the connection to comparators is assured by SWF blocks, each one consisting of $2^{N/2}-1$ switches, under the control of the logic LCC.

The comparators of the COMP block are preferably of the type disclosed in WO 91/19355 filed on May 16th, 1991 on behalf of the same applicant under the title: "Low power dissipation autozeroed comparator circuit" reference to which has to be made for further details. However, other comparing circuits of the known type can be employed.

The S/H circuit essentially includes a capacitance referred to an analog ground voltage, followed by a unit gain de-coupling element. The middle point of the resistive ladder RS, labelled Vref in Fig. 1, is selected as reference analog ground.

We shall now describe the operation of a complete conversion cycle requiring four clock-signals or phases shown in Fig. 4.

During phase $\Phi1$, comparators COMP are autozeroed, and their reference inputs are connected to the $2^{N/2}-1$ reference voltages available at the taps of segments GR, indicated also as coarse reference voltages. At the same time, the input signal Vin is sampled and stored in the S/H circuit.

During subsequent phase $\Phi2$, the inputs of comparators are switched to the output of the S/H circuit, in such a way that each comparator makes the comparison between the sample of the input signal to be coded and one of the reference levels generated by the resistive ladder SR. The output of each comparator, assumes, for instance, the high level when the input signal sample is higher than the reference threshold present at the other input.

On the basis of the $2^{N/2}-1$ logic outputs of comparators, the digital encoder COD determines the N/2 MSBs, according to the selected coding system. This coding system can be of different type and is not described here in detail.

During the same phase $\Phi2$, the outputs of comparators are also feed to the LCC selection combinatorial logic and used to identify one of the main resistive segments GR, and more in detail the one whose upper tap corresponds to a reference voltage immediately higher than the value of the input voltage Vin. The LCC logic generates $2^{N/2}-1$ control signals, controlling in parallel the switch blocks SWF, connected to the taps of the elementary resistances Re of each main resistive segment GR.

During phase $\Phi3$, second autozero phase of the converter, only one of the aforesaid control signal is activated, and it determines the connection of the $2^{N/2}-1$ comparators COMP already used, to the new fine reference values internal to the segment GR identified by the LCC logic.

At the beginning of phase $\Phi4$, second comparison phase, the inputs of comparators are switched again to S/H output to determine the remaining N/2 LABS referring to the voltage Vin stored on the capacitance Ci.

The illustrated converter requires a number of switches on the resistive ladder equal to the sum of $2^{N/2}-1$ (for the MSBs determination) and of $2^{N/2}*(2^{N/2}-1)$ (for LSBs determination). These switches conduct current only during a brief transient, therefore they do not affect the voltage value of the point where references for comparison are withdrawn.

According to the converter of the invention, shown in Fig. 3, however the number of switches can be reduced, and this without adding further control logic circuitry. The same references used in Fig. 1 have been used in Fig. 3 for the components performing equal or similar functions.

The converter of the invention provides for a single switch block SWF connected to the resistances of the middle GR segment of the resistive ladder, whose lower tap is referred to the analog ground voltage (Vref).

Furthermore the capacitance Ci of the sample and hold circuit (S/H) has a plate which can be connected to the input voltage to be converted (Vin), and the other plate selectively connectable to a pedestal voltage (Vlow) chosen by a combinatorial logic LCA, and to the analog ground voltage (Vref).

According to the invention, during the second conversion step, the conversion of the difference between the input voltage Vin and the reference one resulting immediately lower than Vin, is performed. This difference ranges between 0 and $\delta v$, with

$$\delta v = (Vref1 - Vref2)/2^{N/2}$$

and is referred to the analog ground.

The operation of the analog-to-digital converter of Fig. 3 is the following.

During phase $\Phi 1$ the operation is alike that of the converter of Fig. 1.

During phase $\Phi 2$ coding of the MSBs takes place as before. Furthermore, the selection of an appropriate voltage Vlow takes place in this phase, maintaining the voltage to convert during the second conversion step, within the same predetermined voltage interval $\delta v$, for any input voltage. The pedestal voltage Vlow is selected among a finished set of possible values made of the voltages at the taps of GR segments, including Vref1.

Referring to the structure of the S/H circuit shown in Fig. 3, the voltage Vx at the S/H output is equal to (Vin + Vlow - Vref), where Vref corresponds to the middle point of the resistive ladder. Two cases occur which shall be described below, making reference to a 2.5V analog ground voltage Vref.

Case A

Vin $\geq 2.5$V $+ n\delta v < Vin < 2.5 + (n + 1)\delta v$
with n integer ranging from 0 to N/2.

In this case it is selected Vlow = 2.5 - n$\delta$v and voltage Vx becomes:

lower limit 2.5+n$\delta$v-n$\delta$v=2.5
Vx=Vin-2.5+2.5-n$\delta$v{
upper limit 2.5+(N+1)$\delta$v-n$\delta$v=2.5+$\delta$v

Case B

Vin $\leq 2.5$V $2.5 - (n + 1)\delta v < Vin < 2.5 - n\delta v$
In this case it is selected Vlow = 2.5 + (n + 1)$\delta$v and voltage Vx becomes:

lower limit 2.5-(n+1)$\delta$v+(n+1)$\delta$v=2.5
Vx=Vin-2.5+2.5+(n+1)$\delta$v{
upper limit 2.5-n$\delta$v+(n+1)$\delta$v=2.5+$\delta$v

Depending on comparators outputs the selection logic LCA, generates the $2^{N/2}$ control signals to determine Vlow by means of switches SW, being active one signal at a time. Determining the new level of scaled down input voltage is affected by error, due to the parasitic capacitance of the top plate of the hold capacitance Ci, which determines the conversion accuracy. In the implemented realization form this limit is equal to 8 bits.

During phase $\Phi 3$, second autozero phase, comparator inputs, already used for the MSBs, are switched to the voltages of fine reference. These thresholds are obtained at the taps of the elementary resistances Re of the GR resistive segment, referred at the bottom to 2.5 V (Vref) and at the top to (2.5 +$\delta$v) V. At the same time, the bottom plate of the hold capacitance Ci of S/H is connected to the Vlow voltage previously identified.

Finally, during phase $\Phi 4$ the operation is similar to the one previously described referring to Fig. 1. During this phase the capacitance Ci of S/H is referred to Vlow.

With the described structure, the number of switches which persist on the ladder is equal to the sum of $2^{N/2}$-1 (for the MSBs determination) and of $2^{N/2}$-1 + $2^{N/2}$ (for the LSBs determination).

Claims

1. Analog-to-digital converter for the conversion of an input analog signal (Vin) to a N bits digital code, including:

a sample and hold circuit (S/H) receiving at its input terminal the analog signal (Vin) to be converted, the sample and hold circuit comprising a capacitor (Ci), the upper plate of which is connected to the input terminal;

a ladder of resistances (SR) connected in series between two reference voltage sources (Vref1, Vref2) for the generation of intermediate comparison voltages, said ladder consisting of $2^N$ elementary resistances (Re) clustered in $2^{N/2}$ segments (GR), each one comprising $2^{N/2}$ elementary resistances ;

a set of $2^{N/2}$ -1 comparators (COMP) connectable for the comparison between the input signal and said intermediate reference thresholds;

a plurality of latches (LT) connected to the outputs of said comparators;

a coder (COD) to associate a digital code to the output configuration of said comparators, according to preset rules;

a storage buffer (LTU) to store the digital code produced;

characterized by the inclusion of a switch block (SWF) able to connect the reference inputs of comparators (COMP) to the elementary resistances (Re) of a predetermined segment (GR), and whereby the sample and hold circuit (S/H) receives as reference a pedestal voltage (Vlow) and the analog ground voltage (Vref) corresponding to the voltage of the middle point of said ladder of resistances (SR), said pedestal voltage (Vlow) being selected by a combinatorial logic circuit (LCA), connected to the outputs of said latches (LT), by means of one of the switches of another switch block (SW), said switches being provided to connect the taps between said segments (GR) or one of the reference voltage sources (Vref1) to the lower plate of the capacitor (Ci) of the sample and hold circuit (S/H).

2. Analog-to-digital converter according to claim 1, characterized by the fact that said predetermined resistive segment (GR) is the one referred at the bottom to the analog ground (Vref).

3. Analog-to-digital converter according to claim 1 or 2, characterized by the fact that the sample and hold circuit (S/H) includes a storage capacitor the lower plate of which can be connected to said pedestal voltage (Vlow) and to the analog ground voltage (Vref).

4. Analog-to-digital converter according to claims 1, 2 or 3, characterized by the fact that said pedestal voltage (Vlow) is selected among $2^{N/2}$ possible values depending on the value of the analog signal to be converted (Vin), in such a way to reduce the second conversion step to the same predetermined resistive segment (GR), regardless of the value of said analog signal to be converted (Vin).


**Patentansprüche**

1. Analog-digital Wandler zur Umwandlung eines analogen Eingangssignals (Vin) in einen digital Code von N Bits, der folgendes einschließt:
   einen Abtast-Halte-Schaltkreis (S/H), der an seinem Eingang das umzuwandelnde analoge Signal (Vin) empfängt, dieser Abtast-Halte-Schaltkreis schließt einen Kondensator (Ci) ein, dessen obere Elektrode mit dem Eingang verbunden ist;
   einer Kette von Widerständen (SR), die in Serie zwischen zwei Referenzspannungsquellen (Vref1, Vref2) zur Erzeugung von Zwischenvergleichsspannungen eingebunden ist, wobei die genannte Kette aus $2^N$ Elementarwiderständen (Re) besteht, die in $2^{N/2}$ Segmenten (GR), von denen jedes $2^{N/2}$ Elementarwiderstände umfaßt, gebündelt sind;

   einen Satz von $2^{N/2}$ -1 Komparatoren, die zum Vergleich zwischen dem Eingangssignal und den genannten Zwischenreferenzschwellenwerten verbunden werden können;
   eine Mehrzahl von Sperren (LT), die mit den Ausgängen der genannten Koparatoren verbunden sind;
   ein Codierer (COD) zur Verbindung eines Digitalcodes mit der Ausgangskonfiguration der genannten Koparatoren entsprechend vorbestimmter Regeln;
   einen Speicherpuffer (LTU) zur Speicherung der produzierten Codes,
   gekennzeichnet durch das Einschließen einer Schalteinheit (SWF), die geeignet ist, die Referenzeingänge der Koparatoren mit den Elemetarwiderständen (Re) eines vorbestimmten Segments (GR) zu verbinden, und wobei der Abtast-Halte-Schaltkreis (S/H) als Referenz einer Basisspannung (Vlow) und die analoge Massespannung (Vref), die der Spannung des Mittelpunktes der genannten Widerstandskette (SR) entspricht, empfängt, wobei die genannte Basisspannung (Vlow) durch ein logisches Schaltnetz (LCA) ausgewählt wird, das durch einen der Schalter einer anderen Schaltereinheit (SW) mit den Ausgängen der genannten Sperren (LT) verbunden ist, wobei die genannten Schalter der Verbindung der Anschlüsse zwischen den genannten Segmenten (GR) oder einer der Referenzspannungsquellen (Vref1) mit der unteren Elektrode des Kondensators (Ci) des Abtast-Halte-Schaltkreises (S/H) dient.

2. Analog-digital Wandler nach Anspruch 1, dadurch gekennzeichnet, daß das genante vorbestimmte ohmsche Segment (GR) das ist, welches sich unten auf die analoge Masse (Vref) bezieht.

3. Analog-digital Wandler nach Anspruch 1, dadurch gekennzeichnet, daß der Abtast-Halte-Schaltkreis (S/H) einen Speicherkondensator einschließt, dessen untere Elektrode mit der genannten Basisspannung (Vlow) und mit einer analogen Massespannung (Vref) verbunden werden kann.

4. Analog-digital Wandler nach Anspruch 1, 2 oder 3, dadurch gekennzeichnet, daß die genannte Basisspannung (Vlow) unter $2^{N/2}$ möglichen Werten, die vom Wert des analogen umzuwandelnden Signals (Vin) abhängen, ausgewählt wird, und zwar auf eine Weise, daß der zweite Umwandlungsschritt auf das selbe vorbestimmte ohmsche Segment (GR) reduziert wird, ungeachtet des Wertes des genannten analogen umzuwandelnden Signals (Vin).

## Revendications

1. Convertisseur analogique-numérique pour la conversion d'un signal analogique d'entrée (vin) en code numérique à N bits, qui comprend:

   un circuit d'échantillonnage et de maintien (S/H), qui reçoit à son entrée le signal analogique (Vin) à codifier, ce circuit d'échantillonnage et de maintien comprend un condensateur (Ci), dont l'électrode supérieure est reliée à l'entrée;

   une chaîne de résistances (SR) connectée en série entre deux sources de tension de référence (Vref1, Vref2) pour la génération de tensions de référence intermédiaires, la dite chaîne consiste en $2^N$ résistances élémentaires (Re) groupées en $2^{N/2}$ segments (GR), desquels chacun comprend $2^{N/2}$ résistances élémentaires;

   un bloc de $2^{N/2}$ comparateurs (COMP), qui peuvent être reliés pour la comparaison entre le signal d'entrée et les dits seuils de référence intermédiaires;

   une pluralité de circuit de maintien (LT) reliés aux sorties des dits comparateurs;

   un codeur (COD) pour associer un code numérique à la configuration de sortie des dits comparateurs selon des règles préétablies;

   une mémoire tampon (LTU) pour mémoriser le code numérique produit;

   caractérisé par l'inclusion d'une unité interrupteur (SWF) apte à relier les entrée de référence de comparateurs (COMP) aux résistances élémentaires (Re) d'un segment prédéterminé (GR), et où le circuit d'échantillonnage et de maintien (S/H) reçoit comme référence une tension de base (Vlow) et la tension de masse analogique (Vref), qui correspond à la tension du point central de la dite chaîne de résistances (SR), la dite tension de base (Vlow) étant sélectionnée par un circuit logique de combinaison (LCA) relié aux sorties des dits circuits de maintien par un des interrupteurs d'une autre unité interrupteur (SW), les dits interrupteurs étant prévus pour relier les prises entre les dits segments (GR) ou une des sources de tension de référence (Vref1) à l'électrode inférieure du condensateur (Ci) du circuit d'échantillonnage et de maintien (S/H).

2. Convertisseur analogique-numérique comme sous 1, caractérisé en ce que le dit segment résistif prédéterminé (GR) est celui référé inférieurement à la masse analogique (Vref).

3. Convertisseur analogique-numérique comme sous 1 ou 2, caractérisé en ce que le circuit d'échantillonnage et de maintien (S/H) comprend un condensateur de mémoire, dont l'électrode inférieure peut être reliée à la dite tension de base (Vlow) et à la tension de masse analogique (Vref).

4. Convertisseur analogique-numérique comme sous 1, 2 ou 3, caractérisé en ce que la dite tension de base (Vlow) est sélectionnée parmi $2^{N/2}$ valeurs possibles en fonction de la valeur du signal analogique à convertir (Vin) de manière de réduire le deuxième pas de conversion au même segment résistif prédéterminé (GR) indépendamment de la valeur du dit signal d'entrée analogique à convertir (Vin).

Fig.1

EP 0 554 265 B1

Fig. 3

Fig.4

φ1
φ2
φ3
φ4
φSH

T

$GR = 2^{N/2}$

GR1 GRi GRJ $GR\,2^{N/2}$

Vref1 Rα Rα Rα Rα Rα Rα Rα Rα Rα Rα Rα Rα

$R\alpha = 2^{N/2}$  $R\alpha = 2^{N/2}$  Vref  $R\alpha = 2^{N/2}$  $R\alpha = 2^{N/2}$

Fig.2